# EUROPÄISCHE PATENTSCHRIFT

(11) **EP 3 788 654 B1**
(45) Veröffentlichungstag und Bekanntmachung des Hinweises auf die Patenterteilung: **06.12.2023**
(21) Anmeldenummer: 19721605.4
(22) Anmeldetag: 02.05.2019
(51) Int. Cl.: H01L 27/02, H02H 9/04

(54) **SCHUTZSCHALTUNG GEGEN ELEKTROSTATISCHE ENTLADUNGEN**
PROTECTION CIRCUIT AGAINST ELECTROSTATIC DISCHARGES
CIRCUIT DE PROTECTION CONTRE LES DÉCHARGES ÉLECTROSTATIQUES

(30) Priorität: 04.05.2018 DE 102018206896
(43) Veröffentlichungstag der Anmeldung: 10.03.2021
(73) Patentinhaber: Robert Bosch GmbH, 70442 Stuttgart (DE)
(72) Erfinder: GRAF, Michael, 71397 Leutenbach (DE); SEITZINGER, Timo, 72800 Eningen U.A. (DE); LOHMEYER, Henning, 72762 Reutlingen (DE); RAUH, Julia, 72820 Sonnenbuehl (DE)
(86) Internationale Anmeldenummer: PCT/EP2019/061208
(87) Internationale Veröffentlichungsnummer: WO 2019/211361

(56) Entgegenhaltungen:
- EP-A1- 0 490 787
- EP-A1- 2 246 885
- WO-A1-2004/049442
- JP-A- H0 494 161
- US-A1- 2016 126 233

## Beschreibung

Die vorliegende Erfindung betrifft eine Schutzschaltung gegen elektrostatische Entladungen für Anschlussbeine einer anwendungsspezifischen integrierten Schaltung, wobei die Schutzschaltung ein erstes Anschlussbein und ein zweites Anschlussbein aufweist.

Die vorliegende Erfindung betrifft weiter eine anwendungsspezifische integrierte Schaltung mit der Schutzschaltung.

### Stand der Technik

Der Schutz gegen elektrostatische Entladungen, auch ESD-Schutz (engl.: ESD = electrostatic discharge) genannt, von Halbleiterkomponenten nutzt in aller Regel technologie-spezifische Bauelemente, die in Bezug auf Dynamik und Leistung den ESD-Anforderungen angepasst sind. Die Art des ESD-Schutzes spielt an dieser Stelle keine Rolle. Schnittstellen-Anschlussbeine, auch Schnittstellen-Pins genannt, wie zum Beispiel bei der Controller Area Network- (CAN-)Schnittstelle verwenden für gewöhnlich für jedes Anschlussbein separate ESD-Schutzstrukturen. Diese bestehen üblicherweise jeweils aus zwei Schutzstrukturen gegen positiven und negativen Stress, die in Serie geschaltet sind. Es gibt auch Schaltungskonzepte, bei denen die Schutzstrukturen parallel angeordnet oder noch komplexer sind, in diesen Fällen jedoch durch noch größeren Flächenverbrauch wesentlich ungünstiger für die Anwendung sind.

Derartige Schutzstrukturen sind bekannt aus "Case Study of DPI Robustness of a MOS-SCR Structure for Automotive Applications", Yang Xiu et al., Proc. EOS/ESD Symp., 2016, und dem Bosch-Halbleiterchip CY327.

Weitere konventionelle Schutzstrukturen sind aus WO 2004/049442 A1, US 2016/126233 A1, JP H04 94161 A, EP O 490 787 A1 und EP 2 246 885 A1 bekannt.

Die komplexen Anforderungen an Anschlussbeine, insbesondere SystemAnschlussbeine, wie zum Beispiel CAN oder Low-Voltage-Differential-Signal (LVDS) erfordern sehr spezifische ESD-Schutzstrukturen, ohne dass die Funktion in wesentlicher Weise gestört wird. Herkömmliche ESD-Schutzschaltungen haben zudem einen relativ großen Flächenbedarf, was die Stückkosten erhöhen kann. Auch kann eine Robustheit gegen Störpulse, insbesondere Mehrfach-Pulsbelastungen, oft nur mit relativ großem Aufwand realisierbar sein. Manchmal ist problematisch, dass die Schutzschaltung nicht nur auf ESD-Einflüsse, sondern sogar auf normale funktionale Pulse reagiert.

### Offenbarung der Erfindung

Erfindungsgemäß wird eine Schutzschaltung gegen elektrostatische Entladungen für Anschlussbeine einer anwendungsspezifischen integrierten Schaltung zur Verfügung gestellt, wobei die Schutzschaltung ein erstes Anschlussbein und ein zweites Anschlussbein aufweist, wobei das erste Anschlussbein und das zweite Anschlussbein in Y-Konfiguration miteinander verschaltet sind, wobei die Schutzschaltung eine gemeinsame elektronische Schutzstruktur gegen Positivstress für das erste Anschlussbein und für das zweite Anschlussbein aufweist, wobei die Schutzschaltung mehrere elektronische Schutzstrukturen gegen Verpolung des ersten Anschlussbeins und des zweiten Anschlussbeins aufweist, wobei die elektronischen Schutzstrukturen gegen Verpolung und die elektronische Schutzstruktur gegen Positivstress in Y-Konfiguration miteinander verschaltet sind, wobei die Schutzschaltung als elektronische Schutzstrukturen gegen Verpolung einen ersten gesteuerten Siliziumgleichrichter vom N-Typ und einen zweiten gesteuerten Siliziumgleichrichter vom N-Typ aufweist, wobei der erste gesteuerte Siliziumgleichrichter vom N-Typ dem ersten Anschlussbein vorgeschaltet ist und der zweite gesteuerte Silizium-Gleichrichter vom N-Typ dem zweiten Anschlussbein vorgeschaltet ist, die Schutzschaltung als gemeinsame elektronische Schutzstruktur gegen Positivstress einen gesteuerten Siliziumgleichrichter vom P-Typ aufweist, der sowohl dem ersten Anschlussbein als auch dem zweiten Anschlussbein vorgeschaltet ist und der gesteuerte Siliziumgleichrichter vom P-Typ dem ersten gesteuerten Siliziumgleichrichter vom N-Typ und dem zweiten gesteuerten Siliziumgleichrichter vom N-Typ vorgeschaltet ist, wobei das erste Anschlussbein mit einer Anode des ersten gesteuerten Siliziumgleichrichter vom N-Typ elektrisch verbunden ist und das zweite Anschlussbein mit einer Anode des zweiten gesteuerten Siliziumgleichrichter vom N-Typ elektrisch verbunden ist, wobei eine Kathode des ersten gesteuerten Siliziumgleichrichter vom N-Typ mit einer Kathode des zweiten gesteuerten Siliziumgleichrichter vom N-Typ elektrisch verbunden ist, und wobei eine Kathode des gesteuerten Siliziumgleichrichter vom P-Typ sowohl mit der Kathode des ersten gesteuerten Siliziumgleichrichter vom N-Typ als auch mit der Kathode des zweiten gesteuerten Siliziumgleichrichter vom N-Typ elektrisch verbunden ist.

### Vorteile der Erfindung

Die erfindungsgemäße Schutzschaltung hat den Vorteil, dass elektronische Schutzstrukturen von dem ersten Anschlussbein und dem zweiten Anschlussbein gemeinsam genutzt werden können. Auf diese Weise ist eine Flächenreduktion möglich. So kann auch ein symmetrisches Signal, insbesondere bei CAN-Applikationen oder LVDS-Applikationen, erreicht werden.

Vorteilhafte Weiterbildungen der Erfindung sind in den Unteransprüchen angegeben und in der Beschreibung beschrieben.

Die Schutzschaltung weist ein erstes und ein zweites Anschlussbein auf. Die Schutzschaltung weist also mehrere, nämlich mindestens zwei, Anschlussbeine auf. In manchen Ausführungsformen weist die Schutzschaltung jedoch drei oder mehr Anschlussbeine auf, von denen zwei oder mehr in Y-Konfiguration miteinander verschaltet sind. Vorzugsweise sind zwei oder mehr Anschlussbeine der Schutzschaltung mit einem gemeinsamen Mittelknoten der Schutzschaltung elektrisch verbunden.

Die erfindungsgemäße Schutzschaltung weist eine gemeinsame elektronische Schutzstruktur gegen Positivstress für das erste Anschlussbein und für das zweite Anschlussbein auf. In Ausführungsformen mit drei oder mehr Anschlussbeinen kann die Schutzschaltung die gemeinsame elektronische Schutzstruktur gegen Positivstress für zwei oder mehr Anschlussbeine, vorzugsweise für alle Anschlussbeine, aufweisen. Diese Anordnung bedeutet einen Flächenvorteil, da elektrische Bauelemente eingespart werden können.

Die erfindungsgemäße Schutzschaltung weist mehrere elektronische Schutzstrukturen gegen Verpolung des ersten Anschlussbeins und des zweiten Anschlussbeins auf. So können vorzugsweise das erste Anschlussbein und das zweite Anschlussbein durch jeweils eigene elektronische Schutzstrukturen gegen Verpolung geschützt sein. Dies hat zudem den Vorteil, dass unterschiedliche Pins mit unterschiedlichen Verpolungsanforderungen sehr spezifisch und funktions- und flächenoptimiert bedient werden können. In Ausführungsformen mit drei oder mehr Anschlussbeinen kann die Schutzschaltung für jedes Anschlussbein jeweils eine eigene elektronische Schutzstruktur gegen Verpolung aufweisen.

Gemäß der Erfindung ist vorgesehen, dass die elektronischen Schutzstrukturen gegen Verpolung und die elektronische Schutzstruktur gegen Positivstress in Y-Konfiguration miteinander verschaltet sind. Durch die Verkopplung zwischen den elektronischen Schutzstrukturen kommt es zu einer Symmetrisierung des ersten Anschlussbeins und des zweiten Anschlussbeins, insbesondere im Bereich von positiven Betriebsspannungen. Leckstromverhalten, Kapazität und Vorspannung sind dann am ersten Anschlussbein und am zweiten Anschlussbein gleich. Da beispielsweise in CAN-Applikationen ein Differenzsignal des ersten Anschlussbeins und des zweiten Anschlussbeins als Information genutzt wird, ist diese Anordnung den separaten Schutzstrukturen überlegen. Im separaten Fall kann es im Zeitbereich zu Verschiebungen beider Signale kommen, sodass das Differenzsignal nicht eindeutig zu erkennen ist

Gemäß der Erfindung ist vorgesehen, dass die Schutzschaltung als elektronische Schutzstrukturen gegen Verpolung einen ersten gesteuerten Siliziumgleichrichter vom N-Typ und einen zweiten gesteuerten Siliziumgleichrichter vom N-Typ aufweist, wobei der erste gesteuerte Siliziumgleichrichter vom N-Typ dem ersten Anschlussbein vorgeschaltet ist und der zweite gesteuerte Siliziumgleichrichter vom N-Typ dem zweiten Anschlussbein vorgeschaltet ist. Derartige gesteuerte Siliziumgleichrichter werden auch und im Folgenden abgekürzt mit NSCR bezeichnet (engl.: NMOStriggering silicon controlled rectifier). Der erste NSCR und der zweite NSCR weisen jeweils eine Kathode, einen Gate-Anschluss, auch Steueranschluss genannt, und eine Anode auf. NSCR sind weit verbreitet, günstig verfügbar und erprobt. So kann eine zuverlässige Schutzschaltung erreicht werden. Dieser Ansatz gilt nicht nur für SCR-Schutzstrukturen, sondern kann auch auf beliebige andere Schutzstrukturen wie Bipolartransistoren, Dioden, aktive Klammern oder andere Elemente ausgeweitet werden.

Gemäß der Erfindung weist die Schutzschaltung als gemeinsame elektronische Schutzstruktur gegen Positivstress einen gesteuerten Siliziumgleichrichter vom P-Typ auf, der sowohl dem ersten Anschlussbein als auch dem zweiten Anschlussbein vorgeschaltet ist. Derartige gesteuerte Siliziumgleichrichter werden auch und im Folgenden abgekürzt mit PSCR bezeichnet (engl: PMOS-triggering silicon controlled rectifier). Der PSCR weist eine Kathode, einen Gate-Anschluss, auch Steueranschluss genannt, und eine Anode auf. PSCR sind weit verbreitet, günstig verfügbar und erprobt. So kann eine zuverlässige Schutzschaltung erreicht werden. Dieser Ansatz gilt nicht nur für SCR-Schutzstrukturen, sondern kann auch auf beliebige andere Schutzstrukturen wie Bipolartransistoren, Dioden, aktive Klammern oder andere Elemente ausgeweitet werden. Bevorzugt ist, dass in Schutzschaltungen mit drei oder mehr Anschlussbeinen der gesteuerte Siliziumgleichrichter vom P-Typ allen Anschlussbeinen vorgeschaltet ist.

Gemäß der Erfindung ist vorgesehen, dass der gesteuerte Siliziumgleichrichter vom P-Typ dem ersten gesteuerten Siliziumgleichrichter vom N-Typ und dem zweiten gesteuerten Siliziumgleichrichter vom N-Typ vorgeschaltet ist. So kann eine wirkungsvolle Schutzschaltung mit einer reduzierten Anzahl elektrischer Bauelemente erreicht werden, bei der das erste Anschlussbein und das zweite Anschlussbein in Y-Konfiguration miteinander verschaltet sind. Bevorzugt ist, dass in Schutzschaltungen mit drei oder mehr Anschlussbeinen der gesteuerte Siliziumgleichrichter vom P-Typ den jeweiligen gesteuerten Siliziumgleichrichtern vom N-Typ aller Anschlussbeine vorgeschaltet ist.

Einige Ausführungsformen der Schutzschaltung weisen ein Ableitungsmodul auf. Das Ableitungsmodul kann für eine zeitnahe Entladung hoch-ohmiger Knoten in der Schaltung angeordnet sein. So kann es vorteilhafter Weise vor einem möglichen Folgepuls zu einem vollständigen Potentialausgleich innerhalb der integrierten Schaltung kommen. Bevorzugt ist, dass der Mittelknoten zwischen den Schutzstrukturen entlädt. Ist ein Ableitungsmodul für die Entladung gegen Mehrfachpulse vorgesehen, so ist eine Reduktion der Spannungsanforderung an die eingesetzten Bauelemente der Nutzschaltung ermöglicht. Das bedeutet ebenfalls die Möglichkeit einer Flächenreduktion.

In manchen Ausführungsformen ist das Ableitungsmodul dem gesteuerten Siliziumgleichrichter vom P-Typ parallelgeschaltet. Das Ableitungsmodul ist somit vorzugsweise mit einem ersten Anschluss des Ableitungsmoduls mit der Kathode des PSCR und mit einem zweiten Anschluss des Ableitungsmoduls mit der Anode des PSCR elektrisch verbunden. Ein bevorzugtes Ableitungsmodul weist einen Widerstand auf. Besonders bevorzugte Ableitungsmodule enthalten eine Schaltung mit einem variablen Widerstand im Betrieb. Die Parallelschaltung erlaubt, eine einfache und zuverlässige Ableitung zu realisieren.

Ausführungsformen sehen vor, dass die Schutzschaltung ein Abschaltungsmodul aufweist. Bei manchen Ausführungsformen ist die Schutzschaltung dafür eingerichtet, dass der ESD-Schutz dynamisch über schnelle Pulsflanken eingeschaltet wird. Dann ist es von Vorteil, wenn im Betrieb der ESD-Schutz vollständig abgeschaltet oder aber so modifiziert wird, dass er nicht auf "normale" funktionale Pulse reagiert und damit die normale Funktion des Anschlussbeins beziehungsweise der anwendungsspezifischen integrierten Schaltung (auch ASIC genannt) stört. Es ist nämlich durchaus möglich, dass auch im normalen Betrieb Pulse mit Flanken vorkommen, die ähnliche Steilheiten wie ESD-Pulse besitzen, insbesondere eine Steilheit zwischen 0,1 bis 10 V/ns. Manche Ausführungsformen sehen vor, dass das Abschaltungsmodul für eine variable Abschaltung eingerichtet ist. Die variable Abschaltung schwächt den ESD-Schutz, schaltet den ESD-Schutz aber nicht vollständig aus, da auch im Betrieb elektrostatische Entladungen möglich sind. So bleibt auch im Betrieb der anwendungsspezifischen integrierten Schaltung die Schutzschaltung in geschwächter Form aktiv. Das Abschaltungsmodul ermöglicht den Einsatz dynamischer Schutzstrukturen (SCR) für ESD auch bei Schaltungen, die extrem schnelle Signale verarbeiten.

In manchen Ausführungsformen ist das Abschaltungsmodul so angeordnet, dass es für ein oder mehrere Negativschutzelemente der Schutzschaltung, vorzugsweise die Siliziumgleichrichter vom N-Typ, die Negativschutzelemente sind, eingesetzt wird. Hier besteht die Möglichkeit, dass ein gemeinsames Abschaltungsmodul für alle Negativschutzelemente vorgesehen ist. Alternativ ist jedes Negativschutzelement jeweils durch ein eigenes Abschaltungsmodul ausschaltbar. Für jedes Negativschutzelement ist dann ein eigenes Abschaltungsmodul vorgesehen. Einige Ausführungsformen sehen vor, dass jeweils ein Abschaltungsmodul mit dem Gate-Anschluss eines entsprechenden Negativschutzelements, insbesondere des Siliziumgleichrichters vom N-Typ, elektrisch verbunden ist.

Vorzugsweise ist das Abschaltungsmodul elektrisch mit dem Gate-Anschluss des gesteuerten Siliziumgleichrichters vom P-Typ verbunden. Bevorzugt ist, dass das Abschaltungsmodul über einen Verbindungsanschluss des Abschaltungsmoduls elektrisch mit dem Gate-Anschluss des gesteuerten Siliziumgleichrichters vom P-Typ verbunden ist, und dass das Abschaltungsmodul über einen weiteren Verbindungsanschluss des Abschaltungsmoduls mit der Anode des gesteuerten Siliziumgleichrichters vom P-Typ elektrisch verbunden ist. Ein bevorzugtes Abschaltungsmodul ist ein MOS-Schalter, der den PSCR im Betrieb erdet beziehungsweise "grounded". Deshalb ist bevorzugt, dass das Abschaltungsmodul über den weiteren Verbindungsanschluss auch mit einem Erdungsanschluss elektrisch verbunden ist. Alternativ zu einem MOS-Schalter sind in anderen Ausführungsformen andere Schaltertypen vorgesehen. Der Schalter kann über den Gate-Anschluss zuverlässig den PSCR abschalten. Manche Ausführungsformen weisen Abschaltungsmodule für jedes Negativschutzelement jedes Anschlussbeins und zusätzlich ein Abschaltungsmodul für den gesteuerten Siliziumgleichrichter vom P-Typ auf.

In einigen Ausführungsformen ist dem gesteuerten Siliziumgleichrichter vom P-Typ (PSCR) der Erdungsanschluss vorgeschaltet. Vorzugsweise ist die Anode des PSCR mit dem Erdungsanschluss elektrisch verbunden.

Erfindungsgemäß wird weiterhin eine anwendungsspezifische integrierte Schaltung mit einer voranstehend beschriebenen Schutzschaltung zur Verfügung gestellt, bei der das erste Anschlussbein und das zweite Anschlussbein in Y-Konfiguration miteinander verschaltet sind.

Die voranstehend beschriebenen Vorteile und möglichen Ausgestaltungen der Schutzschaltung betreffen gleichermaßen die anwendungsspezifische integrierte Schaltung (ASIC).

Vorzugsweise weist die anwendungsspezifische integrierte Schaltung eine CAN-Schnittstelle oder eine LVDS-Schnittstelle auf. Das erste Anschlussbein ist in Ausführungsformen ein CANH-Anschlussbein. Das zweite Anschlussbein ist in Ausführungsformen ein CANL-Anschlussbein. In anderen Ausführungsformen sind das erste Anschlussbein und das zweite Anschlussbein andere Low-Voltage-Differential-Signal- (LVDS-)Schnittstellen. Das erste Anschlussbein und das zweite Anschlussbein können in Ausführungsformen im Prinzip jede Art von ASIC-System-Anschlussbein oder Schnittstellen-Anschlussbein sein, insbesondere Anschlussbeine differentieller ASIC-Schnittstellen. Die allgemeine Anwendung für HV-ASIC-Anschlussbeine ist ebenfalls möglich.

### Zeichnungen

Ein Ausführungsbeispiel der Erfindung wird anhand der beigefügten Zeichnung und der nachfolgenden Beschreibung näher erläutert. Es zeigt:

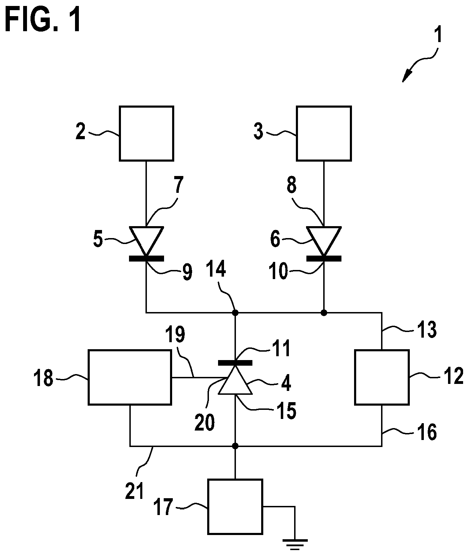

Figur 1 ein Ausführungsbeispiel einer erfindungsgemäßen Schutzschaltung, die einer anwendungsspezifischen integrierten Schaltung enthalten ist.

In der Figur 1 ist eine erfindungsgemäße Schutzschaltung 1 gezeigt, die in einer anwendungsspezifischen integrierten Schaltung enthalten ist.

Die beispielhafte Schutzschaltung 1 weist ein erstes Anschlussbein 2 und ein zweites Anschlussbein 3 auf. Die Schutzschaltung 1 ist somit eine Schutzschaltung 1 gegen elektrostatische Entladungen für Anschlussbeine 2, 3 der anwendungsspezifischen integrierten Schaltung. Die Schutzschaltung 1 ist beispielhaft für eine CAN-Applikation, also ein Grundbeispiel. Die Erfindung ist aber nicht auf die Anwendung in einer CAN-Applikation beschränkt. Im gezeigten Ausführungsbeispiel ist das erste Anschlussbein 2 ein CANH-Anschlussbein. Im gezeigten Ausführungsbeispiel ist das zweite Anschlussbein 3 ein CANL-Anschlussbein. Es gibt aber Ausführungsformen (zur Vereinfachung nicht gezeigt), insbesondere für andere als CAN-Applikationen, die mehr als zwei Anschlussbeine 2, 3 aufweisen.

Wie im Folgenden beschrieben wird, sind das erste Anschlussbein 2 und das zweite Anschlussbein 3 im gezeigten Ausführungsbeispiel in Y-Konfiguration miteinander verschaltet.

Die Schutzschaltung 1 weist eine gemeinsame elektronische Schutzstruktur gegen Positivstress für das erste Anschlussbein 1 und für das zweite Anschlussbein 2 auf. Genauer gesagt, weist die Schutzschaltung 1 als gemeinsame elektronische Schutzstruktur gegen Positivstress einen gesteuerten Siliziumgleichrichter vom P-Typ auf, den PSCR 4, der sowohl dem ersten Anschlussbein 2 als auch dem zweiten Anschlussbein 3 vorgeschaltet ist.

Die Schutzschaltung 1 weist ferner mehrere elektronische Schutzstrukturen gegen Verpolung des ersten Anschlussbeins 2 und des zweiten Anschlussbeins 3 auf. Genauer gesagt, weist die Schutzschaltung 1 als elektronische Schutzstrukturen gegen Verpolung einen ersten gesteuerten Siliziumgleichrichter vom N-Typ, den ersten NSCR 5, und einen zweiten gesteuerten Siliziumgleichrichter vom N-Typ, den zweiten NSCR 6, auf. Der erste NSCR 5 ist dem ersten Anschlussbein 2 vorgeschaltet und der zweite NSCR 6 ist dem zweiten Anschlussbein 3 vorgeschaltet. Das erste Anschlussbein 2 ist direkt, das heißt ohne Zwischenschaltung weiterer Bauteile, mit einer Anode 7 des ersten NSCR 5 elektrisch verbunden. Das zweite Anschlussbein 3 ist direkt mit einer Anode 8 des zweiten NSCR 6 elektrisch verbunden.

Eine Kathode 9 des ersten NSCR 5 ist direkt mit einer Kathode 10 des zweiten NSCR 6 elektrisch verbunden. Eine Kathode 11 des PSCR 4 ist sowohl direkt mit der Kathode 9 des ersten NSCR 5 als auch direkt mit der Kathode 10 des zweiten NSCR 6 elektrisch verbunden. Der PSCR 4 ist also dem ersten NSCR 5 und dem zweiten NSCR 6 vorgeschaltet. Anders ausgedrückt, ist der erste NSCR 5 dem ersten Anschlussbein 2 und dem PSCR 4 zwischengeschaltet und der zweite NSCR 6 ist dem zweiten Anschlussbein 3 und dem PSCR 4 zwischengeschaltet. Auf diese Weise sind die beiden elektronischen Schutzstrukturen gegen Verpolung und die gemeinsame elektronische Schutzstruktur gegen Positivstress in Y-Konfiguration miteinander verschaltet. Das erste Anschlussbein 2 und das zweite Anschlussbein 3 bilden zwei Enden der Y-Konfiguration, während ein drittes Ende der Y-Konfiguration durch den PSCR 4 gebildet ist.

Vorteil der Y-Konfiguration ist, dass bei der CAN-Applikation oder, in anderen Ausführungsbeispielen, anderen LVDS-Interfaces ein symmetrisches Signal für das erste Anschlussbein 2 und das zweite Anschlussbein 3 erreichbar ist. Ebenso ist eine Flächenreduktion erreichbar, da der Positivschutz im gezeigten Ausführungsbeispiel nur einmal verwendet wird.

Die Schutzschaltung 1 weist weiter ein Ableitungsmodul 12 auf, im vorliegenden Fall einen Widerstand. Das Ableitungsmodul 12 ist mit einem ersten Anschluss des Ableitungsmoduls über einen ersten Leiter 13 elektrisch direkt mit der Kathode 9 des ersten NSCR 5, der Kathode 10 des zweiten NSCR 6 und der Kathode 11 des PSCR 4 in einem Mittelknoten 14 verbunden. Das Ableitungsmodul 12 ist mit einem zweiten Anschluss des Ableitungsmoduls 12 direkt mit einer Anode 15 des PSCR 4 über einen zweiten Leiter 16 verbunden. Das Ableitungsmodul 12 ist also dem PSCR 4 parallelgeschaltet. Über den zweiten Leiter 16 ist das Ableitungsmodul 12 zudem direkt mit einem Erdungsanschluss 17 (auch als GND oder Masse bezeichnet) elektrisch verbunden. Das bedeutet, dass der Erdungsanschluss 17 ebenfalls dem PSCR 4 vorgeschaltet ist, genauer gesagt die Anode 15 des PSCR 4 direkt mit dem Erdungsanschluss 17 elektrisch verbunden ist.

Weiterhin weist die Schutzschaltung 1 ein Abschaltungsmodul 18 auf. Das Abschaltungsmodul 18 ist ein MOS-Schalter, der den PSCR 4 im Betrieb "grounded", also die elektrische Verbindung zwischen Anode 15 und dem Erdungsanschluss 18 aktiviert. Das Abschaltungsmodul 18 ist über eine erste Verbindung 19 direkt mit einem Gate-Anschluss 20 des PSCR 4 elektrisch verbunden. Das Abschaltungsmodul 18 ist direkt über eine zweite Verbindung 21 mit der Anode 15 des PSCR 4 elektrisch verbunden. Das Abschaltungsmodul 18 ist zudem direkt über die zweite Verbindung 21 sowohl mit dem Erdungsanschluss 17 wie auch mit der zweiten Seite 16 des Ableitungsmoduls 12 elektrisch verbunden.

Das Abschaltungsmodul 18 und das Ableitungsmodul 12 sind nicht nur für das CANH-Anschlussbein und das CANL-Anschlussbein, sondern auch für alle anderen Systemanschlussbeine anwendbar. Dabei ist das Konzept der Y-Konfiguration unabhängig von der Art der verwendeten ESD-Schutzstrukturen.

Im in Figur 1 gezeigten Ausführungsbeispiel sind zwar häufig direkte Verbindungen zwischen zwei Bauteilen der Schutzschaltung 1 beschrieben. In nicht gezeigten Ausführungsformen können jedoch zwischen die zwei in elektrischer Verbindung miteinander stehenden Bauteile noch weitere Bauteile in der Schutzschaltung 1 anstelle einer solchen direkten Verbindung vorgesehen sein, ohne dass sich dadurch die Funktionsweise der Schutzschaltung 1 verändert.

In nicht gezeigten Ausführungsformen weist die Schutzschaltung 1 drei oder mehr Anschlussbeine 2, 3 auf. Die Schutzschaltung 1 ist also prinzipiell nicht auf das erste Anschlussbein 2 und das zweite Anschlussbein 3 beschränkt. Vorzugsweise ist dann, wie auch in Figur 1, jedem Anschlussbein 2, 3 ein eigenes Negativschutzelement, vorzugsweise ein NSCR 5, 6 vorgeschaltet. Vorzugsweise ist jedem NSCR 5, 6 jedem Anschlussbein 2, 3, wie auch in Figur 1, der gemeinsame PSCR 4 vorgeschaltet. Bevorzugt ist unabhängig von der Anzahl der Anschlussbeine 2, 3, dass jeder NSCR 5, 6 jedes Anschlussbeins 2, 3 mittels der jeweiligen Kathode 9, 10 des NSCR 5, 6 mit dem Mittelknoten 14 direkt verbunden ist, wie auch in Figur 1 gezeigt. In nicht gezeigten Ausführungsformen ist zudem mit einem Gate-Anschluss eines oder mehrerer Negativschutzelemente ein weiteres Abschaltungsmodul 18 elektrisch verbunden. Vorzugsweise ist für jedes Negativschutzelement jedes Anschlussbeins 2, 3 ein weiteres Abschaltungsmodul 18 vorgesehen.

Als Vorteil des Gesamtsystems ist eine integrierte Lösung mit deutlich reduzierter Fläche, was zu einer Kostenersparnis führt, und Robustheit gegen jede Art von Störpulsen, was weitere Applikationsmöglichkeiten erlaubt, erreichbar.

## Patentansprüche

1. Schutzschaltung (1) gegen elektrostatische Entladungen für Anschlussbeine (2, 3) einer anwendungsspezifischen integrierten Schaltung, wobei die Schutzschaltung (1) aufweist:
- ein erstes Anschlussbein (2); und
- ein zweites Anschlussbein (3),
wobei das erste Anschlussbein (2) und das zweite Anschlussbein (3) in Y-Konfiguration miteinander verschaltet sind,
wobei die Schutzschaltung (1) eine gemeinsame elektronische Schutzstruktur gegen Positivstress für das erste Anschlussbein (2) und für das zweite Anschlussbein (3) aufweist,
wobei die Schutzschaltung (1) mehrere elektronische Schutzstrukturen gegen Verpolung des ersten Anschlussbeins (2) und des zweiten Anschlussbeins (3) aufweist,
wobei die elektronischen Schutzstrukturen gegen Verpolung und die elektronische Schutzstruktur gegen Positivstress in Y-Konfiguration miteinander verschaltet sind,
**dadurch gekennzeichnet, dass**
die Schutzschaltung (1) als elektronische Schutzstrukturen gegen Verpolung einen ersten gesteuerten Siliziumgleichrichter vom N-Typ (5) und einen zweiten gesteuerten Siliziumgleichrichter vom N-Typ (6) aufweist, wobei der erste gesteuerte Siliziumgleichrichter vom N-Typ (5) dem ersten Anschlussbein (2) vorgeschaltet ist und der zweite gesteuerte Silizium-Gleichrichter vom N-Typ (6) dem zweiten Anschlussbein (3) vorgeschaltet ist, die Schutzschaltung (1) als gemeinsame elektronische Schutzstruktur gegen Positivstress einen gesteuerten Siliziumgleichrichter vom P-Typ (4) aufweist, der sowohl dem ersten Anschlussbein (2) als auch dem zweiten Anschlussbein (3) vorgeschaltet ist und der gesteuerte Siliziumgleichrichter vom P-Typ (4) dem ersten gesteuerten Siliziumgleichrichter vom N-Typ (5) und dem zweiten gesteuerten Siliziumgleichrichter vom N-Typ (6) vorgeschaltet ist,
wobei das erste Anschlussbein (2) mit einer Anode (7) des ersten gesteuerten Siliziumgleichrichter vom N-Typ (5) elektrisch verbunden ist und das zweite Anschlussbein (3) mit einer Anode (8) des zweiten gesteuerten Siliziumgleichrichter vom N-Typ (3) elektrisch verbunden ist,
wobei eine Kathode (9) des ersten gesteuerten Siliziumgleichrichter vom N-Typ (5) mit einer Kathode (10) des zweiten gesteuerten Siliziumgleichrichter vom N-Typ (6) elektrisch verbunden ist, und
wobei eine Kathode (11) des gesteuerten Siliziumgleichrichter vom P-Typ (4) sowohl mit der Kathode (9) des ersten gesteuerten Siliziumgleichrichter vom N-Typ (5) als auch mit der Kathode (10) des zweiten gesteuerten Siliziumgleichrichter vom N-Typ (6) elektrisch verbunden ist.

2. Schutzschaltung (1) nach Anspruch 1, wobei die Schutzschaltung (1) ein Ableitungsmodul (12) aufweist.

3. Schutzschaltung (1) nach Anspruch 2, wobei das Ableitungsmodul (12) dem gesteuerten Siliziumgleichrichter vom P-Typ (4) parallelgeschaltet ist.

4. Schutzschaltung (1) nach einem der Ansprüche 1 bis 3, wobei die Schutzschaltung (1) ein Abschaltungsmodul (18) aufweist.

5. Schutzschaltung (1) nach Anspruch 4, wobei das Abschaltungsmodul (18) elektrisch mit einem Gate-Anschluss (20) des gesteuerten Siliziumgleichrichters vom P-Typ (4) verbunden ist.

6. Schutzschaltung (1) nach einem der Ansprüche 1 bis 5, wobei ein Erdungsanschluss (17) dem gesteuerten Siliziumgleichrichter vom P-Typ (4) vorgeschaltet ist.

7. Anwendungsspezifische integrierte Schaltung mit einer Schutzschaltung (1) nach einem der vorhergehenden Ansprüche.

8. Anwendungsspezifische integrierte Schaltung nach Anspruch 7, wobei die anwendungsspezifische integrierte Schaltung eine CAN-Schnittstelle oder eine LVDS-Schnittstelle aufweist.

## Claims

1. Protective circuit (1) for protection against electrostatic discharges for terminal pins (2, 3) of an application-specific integrated circuit, wherein the protective circuit (1) comprises:
- a first terminal pin (2); and
- a second terminal pin (3),
wherein the first terminal pin (2) and the second terminal pin (3) are interconnected with one another in a Y-configuration,
wherein the protective circuit (1) comprises a shared electronic protective structure for protection against positive stress for the first terminal pin (2) and for the second terminal pin (3),
wherein the protective circuit (1) comprises a plurality of electronic protective structures for protection against polarity reversal of the first terminal pin (2) and of the second terminal pin (3),
wherein the electronic protective structures for protection against polarity reversal and the electronic protective structure for protection against positive stress are interconnected with one another in a Y-configuration,
**characterized in that**
the protective circuit (1) comprises a first N-type silicon controlled rectifier (5) and a second N-type silicon controlled rectifier (6) as electronic protective structures for protection against polarity reversal, wherein the first N-type silicon controlled rectifier (5) is connected upstream of the first terminal pin (2) and the second N-type silicon controlled rectifier (6) is connected upstream of the second terminal pin (3), the protective circuit (1) comprises a P-type silicon controlled rectifier (4) as shared electronic protective structure for protection against positive stress, which is connected upstream of both the first terminal pin (2) and the second terminal pin (3), and the P-type silicon controlled rectifier (4) is connected upstream of the first N-type silicon controlled rectifier (5) and the second N-type silicon controlled rectifier (6),
wherein the first terminal pin (2) is electrically connected to an anode (7) of the first N-type silicon controlled rectifier (5) and the second terminal pin (3) is electrically connected to an anode (8) of the second N-type silicon controlled rectifier (3),
wherein a cathode (9) of the first N-type silicon controlled rectifier (5) is electrically connected to a cathode (10) of the second N-type silicon controlled rectifier (6), and
wherein a cathode (11) of the P-type silicon controlled rectifier (4) is electrically connected both to the cathode (9) of the first N-type silicon controlled rectifier (5) and to the cathode (10) of the second N-type silicon controlled rectifier (6).

2. Protective circuit (1) according to Claim 1, wherein the protective circuit (1) comprises a dissipation module (12) .

3. Protective circuit (1) according to Claim 2, wherein the dissipation module (12) is connected in parallel with the P-type silicon controlled rectifier (4).

4. Protective circuit (1) according to any of Claims 1 to 3, wherein the protective circuit (1) comprises a turn-off module (18).

5. Protective circuit (1) according to Claim 4, wherein the turn-off module (18) is electrically connected to a gate terminal (20) of the P-type silicon controlled rectifier (4).

6. Protective circuit (1) according to any of Claims 1 to 5, wherein a grounding terminal (17) is connected upstream of the P-type silicon controlled rectifier (4).

7. Application-specific integrated circuit comprising a protective circuit (1) according to any of the preceding claims.

8. Application-specific integrated circuit according to Claim 7, wherein the application-specific integrated circuit comprises a CAN interface or an LVDS interface.

## Revendications

1. Circuit de protection (1) contre les décharges électrostatiques pour les pattes de raccordement (2, 3) d'un circuit intégré spécifique à une application, le circuit de protection (1) présentant :
- une première patte de raccordement (2) ; et
- une deuxième patte de raccordement (3),
dans lequel la première patte de raccordement (2) et la deuxième patte de raccordement (3) sont interconnectées selon une configuration en Y,
dans lequel le circuit de protection (1) présente une structure de protection électronique commune contre une contrainte positive pour la première patte de raccordement (2) et pour la deuxième patte de raccordement (3),
dans lequel le circuit de protection (1) présente plusieurs structures de protection électroniques contre une inversion de polarité de la première patte de raccordement (2) et de la deuxième patte de raccordement (3),
dans lequel les structures de protection électroniques sont interconnectées contre une inversion de polarité et la structure de protection est interconnectée contre une contrainte positive selon la configuration en Y,
**caractérisé en ce que**
le circuit de protection (1) présente en tant que structures de protection électroniques contre une inversion de polarité un premier redresseur au silicium commandé de type N (5) et un deuxième redresseur au silicium commandé de type N (6), dans lequel le premier redresseur au silicium commandé de type N (5) est placé en amont de la première patte de raccordement (2), et le deuxième redresseur au silicium de type N (6) est placé en amont de la deuxième patte de raccordement (3), le circuit de protection (1) présente en tant que structure de protection électronique commune contre la contrainte positive un redresseur au silicium commandé de type P (4) qui est placé en amont aussi bien de la première patte de raccordement (2) que de la deuxième patte de raccordement (3), et le redresseur au silicium commandé de type P (4) est placé en amont du premier redresseur au silicium de type N (5) et du deuxième redresseur au silicium de type N (6),
dans lequel la première patte de raccordement (2) est reliée électriquement à une anode (7) du premier redresseur au silicium commandé de type N (5), et la deuxième patte de raccordement (3) est reliée électriquement à une anode (8) du deuxième redresseur au silicium commandé de type N (3),
dans lequel une cathode (9) du premier redresseur au silicium commandé de type N (5) est reliée électriquement à une cathode (10) du deuxième redresseur au silicium commandé de type N (6), et
dans lequel une cathode (11) du redresseur au silicium commandé de type P (4) est reliée électriquement à la fois à la cathode (9) du premier redresseur au silicium commandé de type N (5) et à la cathode (10) du deuxième redresseur au silicium commandé de type N (6).

2. Circuit de protection (1) selon la revendication 1, dans lequel le circuit de protection (1) présente un module de décharge (12).

3. Circuit de protection (1) selon la revendication 2, dans lequel le module de décharge (12) est monté en parallèle avec le redresseur au silicium commandé de type P (4).

4. Circuit de protection (1) selon l'une quelconque des revendications 1 à 3, dans lequel le circuit de protection (1) présente un module de déconnexion (18).

5. Circuit de protection (1) selon la revendication 4, dans lequel le module de déconnexion (18) est relié électriquement à une borne de grille (20) du redresseur au silicium commandé de type P (4).

6. Circuit de protection (1) selon l'une quelconque des revendications 1 à 5, dans lequel une borne de terre (17) est placée en amont du redresseur au silicium commandé de type P (4).

7. Circuit intégré spécifique à une application, comprenant un circuit de protection (1) selon l'une quelconque des revendications précédentes.

8. Circuit intégré spécifique à une application selon la revendication 7, dans lequel le circuit intégré spécifique à une application présente une interface CAN ou une interface LVDS.
